# EUROPÄISCHE PATENTSCHRIFT

(11) **EP 0 887 623 B1**
(45) Veröffentlichungstag und Bekanntmachung des Hinweises auf die Patenterteilung: **21.08.2002**
(21) Anmeldenummer: 98108581.4
(22) Anmeldetag: 12.05.1998
(51) Int. Cl.: G01D 3/02, G01R 31/28, G01P 3/489

(54) **Sensoreinrichtung**
Sensor arrangement
Agencement de capteur

(30) Priorität: 28.06.1997 DE 19727596
(43) Veröffentlichungstag der Anmeldung: 30.12.1998
(73) Patentinhaber: Volkswagen Aktiengesellschaft, 38436 Wolfsburg (DE)
(72) Erfinder: Degenhardt, Wolfgang, Dipl.-Ing., 38524 Sassenburg (DE)

(56) Entgegenhaltungen:
- EP-A- 0 413 891
- DE-A- 4 408 243

## Beschreibung

Die Erfindung betrifft eine Sensoreinrichtung zur quantitativen Erfassung einer Meßgröße und mindestens eines Schwellwertes der Meßgröße.

Zur Steuerung oder Regelung von Vorrichtungen ist oft neben dem quantitativen Erfassen einer Meßgröße auch das sichere Erkennen von Grenz- oder Schwellwerten notwendig, bei deren Über- oder Unterschreitung die Regelung oder Steuerung entsprechend reagieren muß. So wird beispielsweise bei Klimaanlagen die Leistungsaufnahme eines Kompressors mittels der auftretenden Drücke im Kältekreislauf ermittelt. Stellt sich ein zu hoher Druck ein, weil beispielsweise eine Verstopfung vorliegt, so muß dies erkannt und die Klimaanlage abgeschaltet werden. Ist der auftretende Druck aufgrund einer beispielsweise zu niedrigen Außentemperatur zu gering, so muß ebenfalls die Klimaanlage abgeschaltet werden. Des weiteren wird beim normalen Betrieb der Klimaanlage ein optimaler Arbeitsbereich definiert, bei dessen Überschreitung entgegengeregelt werden soll. Diese gewünschte Sensierung erfolgt über 3-fach Druckschalter. Da trotz der unvermeidlichen Toleranzen bei der Erfassung des Druckes und der Signalübertragung die kritischen Betriebspunkte sicher erfaßt werden müssen, sind hohe Anforderungen an die Genauigkeit des 3-fach Druckschalters zu stellen, so daß diese einen erheblichen Kostenfaktor darstellen.

Aus der DE 40 30 085 ist eine Auswerteschaltung für einen magnetoresistiven Drehzahlsensor mit Komperator und Schalthysterese zur Umsetzung eines analogen Sensorsignals in ein digitales Schaltsignal mit Mitteln, die dem Komperator vorgeschaltet sind, bekannt, um abhängig vom ausgangsseitigen Schaltsignal jeweils einen der Komperatoreingänge mit einem bestimmten Hysteresesignal als Schaltschwelle symmetrisch zu beaufschlagen und ferner mit einem dem Komperatoreingang vorgeschalteten, das Sensorsignal verstärkenden Vorverstärker und einen gleichartig aufgebauten Offsetverstärker, der dem anderen Komperatoreingang vorgeschaltet ist und ein Offsetsignal eines vorgeschalteten Offsetnetzwerkes verstärkt, um eine einfache Offsets und Temperatur-, Versorgungsspannungsschwankungen und Bauteiletoleranzen unterdrückende integrierfähige Schaltung zu schaffen. Die Mittel zur Umsetzung bestehen aus einer Quelle für ein Hysteresesignal, zwei Summiergliedern, von denen je eines zwischen den Verstärkern und dem Komperator angeordnet ist, und einem Schalter, dessen Steueranschluß mit dem Komperatorausgang verbunden ist und die Summierglieder abwechselnd mit der Quelle verbindet.

Aus der DE 195 20 287 ist eine Betriebschaltung für einen Sensor mit einem analogen Ausgangssignal bekannt, wobei das Ausgangssignal des Sensors zumindest in dessen bevorzugten Meßbereich eine annähernd lineare Kennlinie aufweist, bei der Schaltelemente zur Festlegung eines Sollpunktes sowie zur Einstellung der Steigung der Kennlinie vorhanden sind.

Aus dem Fachartikel "Sensoren im Kraftfahrzeug, Dipl.-Ing. Frieder Heintz, Funkschau 26/1982 S.46ff." sind Sensoren mit integriertem Mikroprozessor (Smart Sensors) bekannt, mittels dessen die Kompensation unerwünschter Einflußparameter und ein Toleranzabgleich möglich ist. Weiter sind dort Sensoren mit unterschiedlichen Kennlinien entsprechend den verschiedenen Anwendungsgebieten der Sensoren offenbart. Sensoren mit stetig linearer Kennlinien werden hauptsächlich für kontinuierlich messende Systeme mit weitem Regel- oder Anzeigebereich verwendet, bei denen eine gleichmäßige Meßempfindlichkeit gewünscht wird. Sensoren mit stetig nichtlinearer Kennlinien hingegen finden vorwiegend Verwendung für Systeme mit einem begrenzten Bereich mit großer Meßempfindlichkeit. Sensoren mit einer Stufenfunktion als Kennlinie dienen zur Überwachung von Verschleißkomponenten, deren Ersatz frühzeitig eingeplant werden muß, z.B. Bremsbeläge vor einer Urlaubsfahrt. Des weiteren ist dort ein Sensor mit einer Kennlinie in Form einer Hysterese zu zustandsabhängigen Programmvariation bei komplexen Systemen offenbart, wie beispielsweise die Vollastanreicherung bei voll geöffneter Drosselklappe und Überwachung kritischer Grenzwerte im Fahrzeug.

Aus der EP 0 413 891 A2 ist ein Verfahren und eine Schaltungsanordnung zur Erzeugung einer Eingangsgröße für ein Kreuzspulanzeigeinstrument, insbesondere zur Verwendung in einer Tachoanzeige in einem Fahrzeug, bekannt. Bei diesem bekannten Verfahren sollen unerwünschte ruckweise Bewegungen der Tachonadel bei geringer Fahrgeschwindigkeit, die in Folge einer geringen Signalabgabefrequenz des Geschwindigkeitssensors entstehen, unterdrückt werden. Dies wird dort durch die Ausgabe eines Geschwindigkeitswertes von Null an das Anzeigeinstrument bei Unterschreitung einer vorgegebenen, relativ geringen Fahrgeschwindigkeit erreicht. Die Problematik, die Druckschalter zu ersetzen oder einzelne Schwellwerte genau zu sensieren und dabei gleichzeitig einen weiten Meßbereich zu bieten, ist dort nicht angesprochen.

Nachteilig an allen bekannten Sensoren bzw. Sensoreinrichtungen ist, daß diese nicht die dreifach Druckschalter ersetzen können, da diese nicht gleichzeitig einen weiten Meßbereich und einzelne Schwellwerte genau sensieren können.

Der Erfindung liegt daher die Aufgabe zugrunde, eine Sensoreinrichtung zu schaffen, mit der über einen großen Meßbereich eine zu erfassende Meßgröße und einzelne Schwellwerte genau sensierbar sind.

Die Lösung der Aufgabe ergibt sich durch die Merkmale des Patentanspruchs 1.

Durch die Ausbildung der Kennlinie als stetig differenzierbare Funktion, die beim Schwellwert einen Sprung aufweist, der größer als die Summe aller möglichen Toleranzen ist, kann der vom Sensor erfaßte Schwellwert sicher zu einer das Signal verarbeitenden Steuereinheit
übertragen werden, so daß Toleranzen bei der Signalübertragung und der Erfassung des übertragenen Signals durch die Steuereinheit kompensiert werden. Übrig bleiben nur noch die Toleranzen des Sensors selbst. Dadurch ergibt sich eine Kombination der hohen Auflösung eines Analogsignals mit der sicheren Übertragung eines Digitalsignals, wobei die Sprunghöhe der Kennlinie beim Schwellwert sinngemäß der Noise-Margin eines Digital-Gatters entspricht, also der minimalste Signalhub, bei dem ein Eingangssignal sicher erkannt wird.

Weitere vorteilhafte Ausgestaltungen der Erfindung ergeben sich aus den Unteransprüchen.

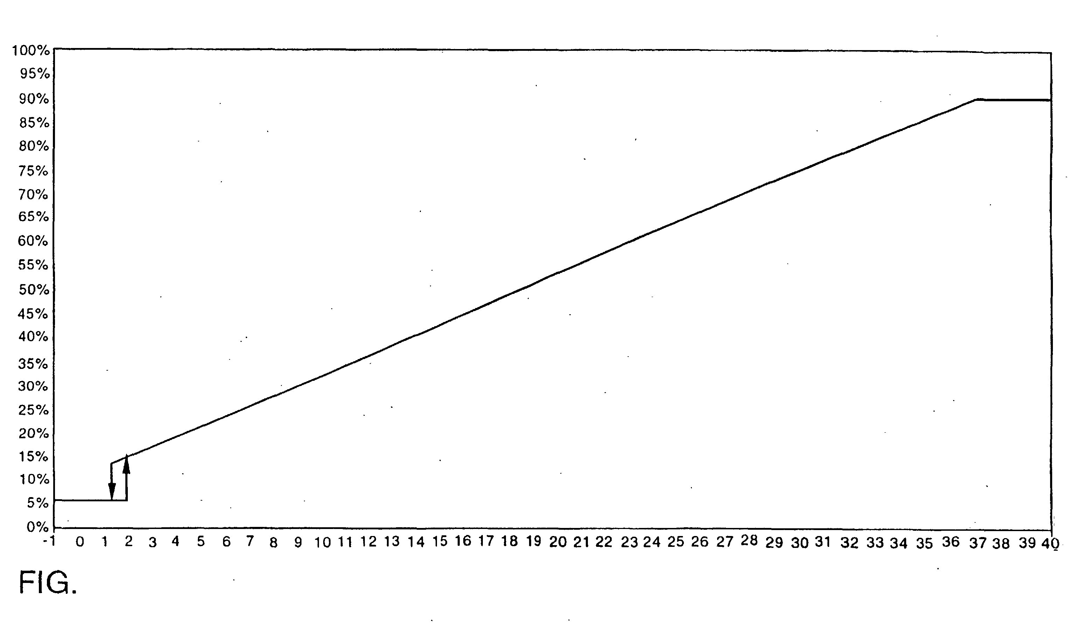

Die Erfindung wird nachfolgend anhand eines bevorzugten Ausführungsbeispieles näher erläutert. Die einzige Figur zeigt die Kennlinie eines Drucksensor mit einem pulsweitenmoduliertem Ausgangssignal in % über den Druck in bar.

Die Kennlinie des Sensors läßt sich im wesentlichen in vier Bereiche unterteilen, nämlichen jeweils einen konstanten Anteil bei sehr niedrigen und sehr hohen Drücken, eine hystereseförmigen Anteil beim Schwellwert und einen linearen Bereich. Im Druckbereich bis zu ca. 1,2 bar ist das Ausgangssignal konstant 5% pulsweitenmoduliert. Tritt daher am Ausgang des Sensor ein Dauer-Low-Signal auf, so muß dies auf einen Kurzschluß gegen Masse zuruckzuführen sein. Analog kann bei einem Dauer-High-Signal am Ausgang des Sensors auf einen Kurzschluß mit der Betriebsspannung zurückgeschlossen werden. Die quantitative Auswertung des Druckes erfolgt daher nur im Bereich zwischen 1,2 und 37 bar. In diesem Bereich besteht ein linearer Zusammenhang zwischen dem Druck und dem pulsweitenmoduliertem Ausgangssignal des Sensors.

Bei der Übertragung des Ausgangssignals zu einer weiterverarbeitenden Signalauswertungseinrichtung ist zu berücksichtigen, daß das Signal Störeinflüssen unterworfen ist, so daß die Auswertung nur mit unvermeidlichen Toleranzen möglich ist. Hinzu kommen noch die Bauteiletoleranzen des Sensors selbst, sowie die der Signalauswertungseinrichtung. Bei Erreichen der 1,2 bar hingegen macht das Ausgangssignal einen Sprung von ca. 8% in der Pulsweitenmodulation. Die Sprunghöhe ist dabei derart gewählt, daß diese größer als die maximal auftretenden Toleranzen von Signalübertragung und Bauteilen der Signalauswerteeinrichtung ist und somit sicher von der Signalauswerteeinrichtung erfaßt wird.

Dient das Ausgangssignal des Sensors beispielsweise zur Steuerung eines Kompressor für eine Klimaanlage, so muß der Kompressor bei Erreichen bzw. Unterschreiten eines bestimmten Schwellwertes abgeschaltet werden. Um nun aber zu verhindern, daß der Kompressor ständig ein- und ausgeschaltet wird, ist die Kennlinie am Schwellwert hystereseförmig ausgebildet. Somit muß nach Abschaltung des Kompressors der durch den Sensor erfaßte Druck im Kältekreislauf den Schwellwert deutlich übersteigen, bevor das Ausgangssignal wieder in den linearen Bereich hochspringt. In der dargestellten Kennlinie geschieht dies bei 2 bar und die Pulsweitenmodulation des Ausgangssignals wird sprunghaft um 10% erhöht. Dies wird von der Signalauswerteeinrichtung erfaßt und von dieser der Kompressor wieder eingeschaltet.

Bei Bedarf können mehrere Schwellwerte berücksichtigt werden, die auch innerhalb des linearen Bereiches liegen können. Dies kann einerseits erforderlich sein, falls eine zu steuernde Komponente mehrere kritische Bereiche aufweist, oder aber mittels einer erfaßten Meßgröße verschiedene unabhängige Komponenten gesteuert werden sollen.

## Patentansprüche

1. Sensoreinrichtung zur quantitativen Erfassung einer Meßgröße und mindestens eines Schwellwertes der Meßgröße, umfassend einen Sensor mit einem analogen Ausgangssignal und einen die Kennlinie des Sensors veränderbaren Einrichtung, insbesondere eines Mikroprozessors, wobei die ansonsten stetig differenzierbare Kennlinie des Sensors beim Schwellwert einen Sprung aufweist, der größer als die Summe aller auftretenden Toleranzen ist, **dadurch gekennzeichnet, daß** der Sprung als Hysterese-Kurve ausgebildet ist.

2. Sensoreinrichtung nach Anspruch 1, **dadurch gekennzeichnet, daß** die Kennlinie im unteren Meßbereich als konstante Funktion ungleich null ausgebildet ist.

3. Sensoreinrichtung nach einem der vorangegangenen Ansprüche, **dadurch gekennzeichnet, daß** die Kennlinie im oberen Meßbereich als konstante Funktion ungleich der maximal auftretbaren Bezugsgröße ausgebildet ist.

4. Sensoreinrichtung nach einem der vorangegangenen Ansprüche, **dadurch gekennzeichnet, daß** der Sensor als Drucksensor mit pulsweitenmoduliertem Ausgangssignal ausgebildet ist.

5. Sensoreinrichtung nach Anspruch 4, **dadurch gekennzeichnet, daß** die Sensoreinrichtung zur Ermittlung des Druckes im Kühlkreislauf einer Klimaanlage verwendet wird.

## Claims

1. Sensor device for quantitative detection of a measurement variable and of at least one threshold value of the measurement variable, comprising a sensor having an analogue output signal, and a device which can vary the characteristic of the sensor, in particular a microprocessor, with the characteristic of the sensor, which can otherwise be differentiated continuously, having a step-function change, which is greater than the sum of all the tolerances that occur, at the threshold value, **characterized in that** the step-function change is in the form of a hysteresis curve.

2. Sensor device according to Claim 1, **characterized in that** the characteristic is in the form of a constant function, not equal to zero, in the lower measurement range.

3. Sensor device according to one of the preceding claims, **characterized in that** the characteristic is in the form of a constant function, not equal to the maximum reference variable which can occur, in the upper measurement range.

4. Sensor device according to one of the preceding claims, **characterized in that** the sensor is in the form of a pressure sensor with a pulse-width-modulated output signal.

5. Sensor device according to Claim 4, **characterized in that** the sensor device is used for determining the pressure in the cooling circuit of an air conditioning system.

## Revendications

1. Agencement de capteur pour la détection quantitative d'une grandeur à mesurer et au moins une valeur de seuil de la grandeur à mesurer, comprenant un capteur avec un signal de sortie analogique et un dispositif permettant de modifier la courbe caractéristique du capteur, plus particulièrement un microprocesseur, dans quel cas la courbe caractéristique du capteur qui peut généralement être différenciée constamment présente un saut en présence d'une valeur de seuil, lequel est supérieur à la somme de toutes les tolérances qui apparaissent, **caractérisé en ce que** le saut se présente sous la forme d'une courbe d'hystérésis.

2. Agencement de capteur selon la revendication 1, **caractérisé en ce que** la courbe caractéristique se présente dans la plage de mesure inférieure comme une fonction constante différente de zéro.

3. Agencement de capteur selon l'une des revendications précédentes, **caractérisé en ce que** la courbe caractéristique se présente dans la plage de mesure supérieure comme une fonction constante différente de la grandeur de référence maximale pouvant apparaître.

4. Agencement de capteur selon l'une des revendications précédentes, **caractérisé en ce que** le capteur est réalisé sous la forme d'un capteur de pression avec un signal de sortie modulé en largeur d'impulsion.

5. Agencement de capteur selon la revendication 4, **caractérisé en ce que** l'agencement de capteur est utilisé pour déterminer la pression dans le circuit de fluide frigorigène d'un équipement de climatisation.
